(19) Europäisches Patentamt

European Patent Office

Office européen des brevets

(11) **EP 1 732 231 A2**

(12) **EUROPEAN PATENT APPLICATION**

(43) Date of publication:
**13.12.2006 Bulletin 2006/50**

(51) Int Cl.:
*H04B 1/04* *(2006.01)*      *H03G 3/20* *(2006.01)*

(21) Application number: **06115069.4**

(22) Date of filing: **07.06.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **10.06.2005 US 149873**

(71) Applicant: **M/A-Com Eurotec B.V.**
**1043 DP  Amsterdam (NL)**

(72) Inventors:
• **Carey,, Eoin**
**Cork (IE)**

• **Prikhodko, Dima**
**Rochestown, Co. Cork (IE)**
• **Grebennikow, Andrei Viktorovich**
**Little Island, Co. Cork (IE)**

(74) Representative: **Johnstone, Douglas Ian et al**
**Baron & Warren,**
**19 South End,**
**Kensington**
**London W8 5BU (GB)**

(54) **System and method for controlling power output from a power amplifier**

(57)     Systems and methods for controlling output power from a power amplifier (110) include a power amplifier (110) configured to generate a power output signal. An output matching circuit (120) is in communication with the power amplifier (110) and is configured to provide an impedance match between the power amplifier (110) and the load (170). The output matching circuit (120) includes a coupler circuit (130) configured to detect the level of the power output signal. The coupler (130) circuit is further configured to generate a coupler circuit output signal that is proportional to the detected output power level. A feedback control loop (150) circuit is in communication with the coupler circuit (130) and the power amplifier (110). The feedback control loop circuit (150) is configured to control the power output level based at least in part on the coupler circuit output signal.

FIGURE 1

**Description**

The invention relates generally to power control in a wireless communication transmitter and, more particularly, to a system and method for controlling power output from a power amplifier.

Power control is increasingly important in wireless communication systems, such as mobile or cellular telephone systems. To improve efficiency and extend battery life, wireless communication devices typically regulate their power output levels in accordance with system and environmental demands. For example, wireless communication devices may automatically control their radiated power output level to maintain satisfactory communication with a base station. As a wireless communication device is moved around in relation to a fixed base station, it may require more or less power to maintain satisfactory communication, depending on factors such as the distance between the device and the base station. At longer distances, more power typically is required to maintain satisfactory communication with the base station. By contrast, at shorter distances, the power output may be reduced to conserve energy and extend the battery life in the wireless device.

The power transmitted by a wireless communication device typically is provided by a power amplifier within the device. The range of power output levels required by the wireless communication device may be quite large, such as 35 dBm. Depending on the power output level, power amplifiers for wireless communications devices typically may achieve up to about sixty percent efficiency, where efficiency is measured as the ratio of signal output power transmitted by the amplifier to the operating power provided to the amplifier by a power source, such as a battery.

Wireless communication devices also may include circuitry, such as a feedback loop, to monitor and control the output level of the power amplifier. For example, one such device includes a coupler provided between the output matching circuit and the load and configured to sense part of the power output signal provided to the load. Some systems sense a voltage or current associated with the output power level. Another type of system senses the incident power of the output signal to the load.

Each of these systems, however, has disadvantages. For example, the use of a coupler at the output of the power amplifier matching circuitry reduces the efficiency of the transmitter by introducing an additional insertion loss. The coupler also increases the size of the power amplifier. In addition, these systems may not provide an accurate measure of the actual power output level. The systems that sense voltage or current associated with the power output only account for the amplitude of the voltage or current. For accurate power detection, it may be important to account for both amplitude and phase. Similarly, the system that senses incident power may fail to accurately sense the true power output level because it does not account for any reflected power if there is an impedance mismatch at the load.

Accordingly, there is a need for a system and method that accurately senses and controls the power output from a power amplifier. There is a further need for a system and method for sensing and controlling the power output from a power amplifier that provides for a reduced size of the power amplifier. There is a further need for a system and method that senses and controls the power output from a power amplifier and maximizes the power efficiency by minimizing any losses associated with the power control circuitry.

The solution is provided by a system for controlling output power from a power amplifier that includes a power amplifier configured to generate a power output signal. An output matching circuit including a coupler is in communication with the power amplifier and is configured to provide an impedance match between the power amplifier and the load. A power detection circuit is in communication with the coupler and is configured to detect the level of the power output signal. The power detection circuit is further configured to generate a power detection output signal that is proportional to the detected output power level. A feedback control loop circuit is in communication with the power detection circuit and the power amplifier. The feedback control loop circuit is configured to control the power output level based at least in part on the power detection output signal.

The solution is also provided by a method for controlling output power from a power amplifier that includes generating a power output signal from a power amplifier. An output matching circuit is configured to provide an impedance match between the power amplifier and the load. The level of the power output signal is detected using a coupler that is part of the output matching circuit. A power detection output signal is generated that is proportional to the detected output power level of the power output signal. The power amplifier is controlled to adjust the output power level based at least in part on the power detection circuit output signal.

The components in the figures are not necessarily to scale, emphasis instead being placed upon illustrating the principles of the invention. Moreover, in the figures, like referenced numerals designate corresponding parts throughout the different views. The invention will now be described by way of example with reference to the accompanying drawings.

Figure 1 is a block diagram of a system for controlling the power output from a power amplifier according to one aspect of the invention.

Figure 2 is a block diagram of a matching circuit according to another aspect of the invention.

Figure 3 is a flow diagram of a method for controlling the power output from a power amplifier according to another aspect of the invention.

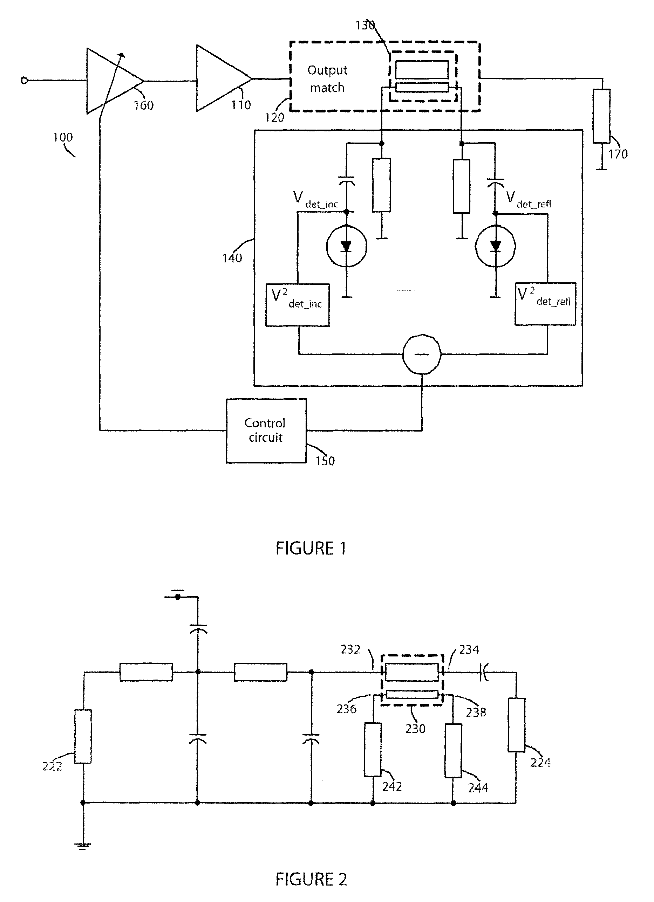

Embodiments of the invention include apparatus, methods and articles of manufacture for processing electromagnetic waves and signals. For illustration purposes, an exemplary embodiment comprises a power amplifier system. The power amplification systems and methods described in this application may be implemented in a wide range of applications, such as, for example, transmitters, transceivers, etc. For purposes of illustration, an exemplary power amplification system according to one aspect of the invention is illustrated in Figure 1.

The exemplary power amplifier system 100 illustrated in Figure 1 may include, for example, a power amplifier 110, an output matching circuit 120, a coupler 130, a power detection circuit 140, a feedback control loop circuit 150, and a variable gain amplifier 160. Various components of the exemplary power amplifier, which are described in more detail below, may be analog or digital in nature. The exemplary power amplifier also may include a combination of analog and digital components.

The term "signal" as is used herein should be broadly construed to include any manner of conveying data from one place to another, such as, for example, an electric current or electromagnetic field, including without limitation, a direct current that is switched on and off or an alternating-current or electromagnetic carrier that contains one or more data streams. Data, for example, may be superimposed on a carrier current or wave by means of modulation, which may be accomplished in analog or digital form. The term "data" as used herein should also be broadly construed to comprise any type of intelligence or other information, such as, for example and without limitation, audio, video, and/or text information.

As illustrated in Figure 1, an output matching circuit 120 provides impedance matching between a power amplifier 110 and a load 170. Typically, it is beneficial to match impedances to provide efficient power transfer between an amplifier and a load. Impedance matching generally is dependent on the frequency of the transfer signal. As a result, for the power amplifier system 100 to operate on different frequency bands (e.g., 880-915 MHz for GSM900, 1710-1785 MHz for DCS1800, and 1850-1910 MHz for PCS1900) it may be necessary to provide separate impedance matching circuits for each of the various operating bands. In addition, it may also be necessary to provide separate power amplifiers for each of the required frequency bands.

The output matching circuit 120 includes a coupler 130. For instance, the coupler 130 may be a passive device through which passes the output signal from the power amplifier 110. The coupler 130 may include two transmission lines arranged closely enough together that energy passing through one line is coupled to the other line. In a typical four-port coupler, the output signal from the power amplifier 110 is received at the input port and transmitted via the main line to the transmit port. A portion of the energy passing through the main line is transferred to the coupled line and provided at one of the two coupled ports of the coupler. Thus, without interrupting the main power flow from the power amplifier 110 to the load 170, the coupler 130 obtains information about the power level of the output signal from the power amplifier 110.

The coupler 130 causes a small loss of power in the output signal, but this loss may be minimized by minimizing the size of the coupler 130. By including the coupler 130 as part of the output matching circuit 120, the size of the coupler may be substantially reduced. As a result, the size of the power amplification system 100 also may be reduced. In addition, the coupler 130 serves the dual purposes of detecting the output power level and providing part of the output matching circuit. This eliminates the need for a separate coupler beyond the output matching circuit 120, which would otherwise degrade the efficiency of the amplifier. The increased efficiency resulting from including the coupler 130 as part of the output matching circuit 110 can be significant. For example, providing a smaller coupler 130 as part of the output matching circuit 110 instead of relying on a larger coupler at the load results in an increase in power-added efficiency of approximately one to three percent, and possibly more.

A power detection circuit 140 is in communication with the matching circuit coupler 130. The power detection circuit 140 receives signals from both of the coupled ports of the coupler 130. An incident coupled port of the coupler 130 provides a signal representative of the incident power component of the output signal from the power amplifier 110. A reflected coupled port of the coupler 130 provides a signal representative of the reflected power component of the output signal. The power detection circuit 140 may use one or both of these signals to detect the actual power level transmitted by the power amplifier 110.

Based on the incident and reflected power component signals, the power detection circuit 140 determines a total detected power level of the output signal from the power amplifier 110. The determination may be based in part on the designed coupling coefficient, k, of the coupler 130. The coupling coefficient represents the ratio:

$$k = \frac{P_{inc} - P_{refl}}{P_{out}}, \qquad\qquad (1)$$

where $P_{inc}$ is the incident power component, $P_{refl}$ is the reflected power component, and $P_{out}$ is the total power of the output signal from the power amplifier. Similarly, the relationship between the total and component voltages may be represented as

$$V_{\det} = n(V_{\det\_inc}^2 - V_{\det\_refl}^2)$$ , (2)

where $V_{det\_inc}$ is the detected voltage of the incident component of the power output signal, $V_{det\_refl}$ is the detected voltage of the reflected component of the power output signal, and n is a coefficient having a dimension of 1/volt.

Based on equations (1) and (2), the total detected power output may be determined as

$$P_{out} = \frac{V_{\det}}{n \times Z_t \times k}$$ , (3)

where $Z_t$ is the termination impedance of the coupler, which typically may be 50 ohms. As equation (3) demonstrates, the total output, or delivered, power depends linearly on $V_{det}$ and the coupling factor *k*. The total output power is independent of the phase and the voltage standing wave ratio (VSWR). This approach also accounts for both the incident and reflected components of the output signal from the power amplifier 110, where the reflected component exists if there is an impedance mismatch at the load.

The power detection circuit 140 may include circuitry based on equation (3) or equivalent to determine the detected output power. The output from this circuitry is a power detection output signal, which the power detection circuit provides to a feedback control loop circuit 150. The feedback control loop circuit 150 uses the power detection output signal as a low-frequency control signal to control the output power of the power amplifier 110. Alternatively, the feedback control loop circuit 150 may generate a low-frequency control signal based on the power detection output signal.

The feedback control loop circuit 150 controls the output power of the power amplifier 110 by varying the gain of a variable gain amplifier 160 provided in series before the power amplifier 110. Alternatively, the feedback control loop circuit 150 may control the output power of the power amplifier 110 in other ways, such as by direct control of the power amplifier 110.

A block diagram of an output matching circuit 220 according to another aspect of the invention is illustrated in Figure 2. The output matching circuit 220 provides impedance matching between the power amplifier 110 and the load 170, as noted above with respect to Figure 1. This ensures efficient transfer of power from the power amplifier 110 to the load 170. For example, the output impedance of the power amplifier 110 may be 2 ohms, and the impedance of the load 170 may be 50 ohms. In this case, the output matching circuit 220 may have an impedance of 2 ohms at its input 222 and an impedance of 50 ohms at its output 224.

As noted above, a coupler 230 is included as part of the output matching circuit 220. Thus, the total impedance matching between the power amplifier 110 and the load 170 is provided by a combination of the coupler 230 and the other elements in the output matching circuit 220. Because the coupler 230 is integrated within the output matching circuit 220, it does not add any additional losses to the power amplifier system 100 beyond that caused by normal output impedance matching. Thus, by including the coupler 230 as part of the matching circuit 220, an increase in efficiency is obtained compared to a system that uses a coupler at the load (e.g., after matching to 50 Ohms) to detect delivered power because using a coupler at the load would introduce additional losses to the power amplifier system 100.

Figure 2 also illustrates the ports of a typical four-port coupler. The coupler receives the power output signal at the input coupler port 232 and transmit the signal via the main line to the transmit coupler port 234. The coupler also outputs a signal representative of the incident power component of the power output signal. The coupler outputs this signal via the incident coupler port 236. This signal may be detected as a voltage $V_{det\_inc}$ across a transmission line 242 connected between the incident coupler port 236 and ground. Likewise, the coupler outputs a signal representative of the reflected power component of the power output signal. The coupler outputs this signal at the reflected coupler port 238. This signal may be detected as a voltage $V_{det\_refl}$ across a transmission line 244 connected between the reflected coupler port 238 and ground. The two transmission lines 242 and 244 connected between the coupler and ground may, for example, have impedances of 50 ohms.

The power detection circuit 140 shown in Figure 1 includes a voltage subtractor. The voltage subtractor is configured to provide a total detected output voltage $V_{det}$ representative of a factor based on the difference between the square of the voltage $V_{det\_inc}$ detected from the incident power component and the square of the voltage $V_{det\_refl}$ detected from the reflected power component. The total detected output voltage is then output from the power detection circuit as a power detection output signal.

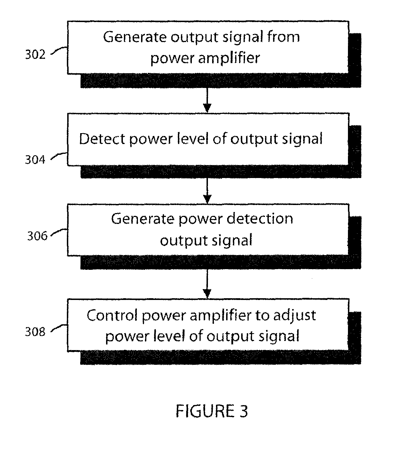

Figure 3 is a flow diagram of a method for controlling the power output from a power amplifier according to another aspect of the invention. A power output signal is generated from the power amplifier 110, as illustrated by block 302. The output power level of the power output signal is detected, as illustrated by block 304. The output power level may be detected using the coupler 130 that is part of the output matching circuit 120, as shown in Figure 1. The detected output power level may be based on both the incident and the reflected components of the power output signal. For example, a voltage $V_{det\_inc}$ may be detected from the incident power component of the power output signal, and a voltage $V_{det\_refl}$ may be detected from the reflected power component of the power output signal. A total detected voltage $V_{det}$ may be determined using equation (2), described above. The total detected output power level $P_{out}$ may then be determined using equation (3), also described above.

Based on the total detected output power level, a power detection output signal is generated, as illustrated by block 306. The power detection output signal is proportional to the detected output power level of the power output signal. The power amplifier is then controlled to adjust the output power level based at least in part on the power detection output signal, as illustrated by block 308.

The system and method for controlling output power of a power amplifier described herein provide effective and efficient control of the total power output. For example, even with significant impedance mismatch, these methods and systems may reduce open-loop power deviations of 5 dB down to about 0.5 dB with the feedback control loop closed. In addition, the system and method may provide a nearly linear amplification from about 0 dB to over 35 dB.

Embodiments of the invention may include power amplifier systems that are specialized for particular input signals, carrier waves, and output signals. For example, such power amplifier systems may be specialized for use with mobile telephones, such as for use with CDMA, CDMA2000, W-CDMA, GSM, and TDMA systems, as well as with other wired and wireless devices, such as those for use with Bluetooth, 802.11a, -b, -g, and -n, radar, 1xRTT, two-way radio, GPRS, EDGE, computers and computer communication devices, personal digital assistants, and other handheld devices.

**Claims**

1. A system (100) for controlling output power from a power amplifier (110), comprising:

    a power amplifier (110) configured to generate a power output signal;
    an output matching circuit (120) in communication with the power amplifier (110) and configured to provide an impedance match between the power amplifier (110) and a load (170), the output matching circuit (120) including a coupler (130);
    a power detection circuit (140) in communication with the coupler (130) and configured to detect an output power level of the power output signal and to generate a detection output signal that is proportional to the detected output power level; and
    a feedback control loop circuit (150) in communication with the power detection circuit (140) and the power amplifier (110) and configured to control the output power level based at least in part on the detection output signal.

2. A system (100) for controlling output power from a power amplifier (110) as in claim 1, wherein the coupler (130) is integrally formed within the output matching circuit (120).

3. A system (100) for controlling output power from a power amplifier (110) as in claim 1, where the power detection circuit (140) is further configured to generate the power detection output signal based on both an incident component of the power output signal and a reflected component of the power output signal.

4. A system (100) for controlling output power from a power amplifier (110) as in claim 1, where the coupler (130) is connected in series with the load (170).

5. A system (100) for controlling output power from a power amplifier (110) as in claim 1, where:

    the power detection circuit (140) is further configured to determine a detected voltage $V_{det}$ of the detected power output level based on

$$V_{det} = n\left(V_{det\_inc}^2 - V_{det\_refl}^2\right),$$

    where $V_{det\_inc}$ is a detected voltage of an incident component of the power output signal, $V_{det\_refl}$ is a detected voltage of a reflected component of the power output signal, and n is a coefficient having a dimension of 1/volt; and

the power detection circuit (140) is further configured to determine the detected output power level $P_{out}$ based on

$$P_{out} = \frac{V_{\det}}{n \times Z_1 \times k},$$

where $Z_1$ is a termination impedance of the coupler (130), and k is a coupling factor of the coupler (130).

6. A system (100) for controlling output power from a power amplifier (110) as in claim 1, where the output matching circuit (120) is configured to provide impedance matching within a frequency range of approximately 880 MHz to 915 MHz.

7. A system (100) for controlling output power from a power amplifier (110) as in claim 1, where the output matching circuit (120) is configured to provide impedance matching within a frequency range of approximately 1710 MHz to 1785 MHz.

8. A system (100) for controlling output power from a power amplifier (110) as in claim 1, where the output matching circuit (120) is configured to provide impedance matching within a frequency range of approximately 1850 MHz to 1910 MHz.

9. A method for controlling output power from a power amplifier (110), comprising:

   generating (302) a power output signal from a power amplifier (110);
   detecting (304) an output power level of the power output signal using a coupler (130) that is integrated within an output matching circuit (120) configured to provide an impedance match between the power amplifier (110) and a load (170);
   generating (306) a power detection output signal that is proportional to the detected output power level of the power output signal; and
   controlling (308) the power amplifier to adjust the output power level based at least in part on the power detection output signal.

10. A method for controlling output power from a power amplifier (110) as in claim 9, where:

   the detection (304) of the output power level further includes detecting both an incident component of the power output signal and a reflected component of the power output signal; and
   the generation (306) of the power detection output signal is based on both the incident component and the reflected component.

11. A method for controlling output power from a power amplifier (110) as in claim 9, where the coupler (130) is connected in series with the load (170).

12. A method for controlling output power from a power amplifier (110) as in claim 9, further comprising:

   determining a detected voltage $V_{det}$ of the detected power output level based on

$$V_{\det} = n \left( V_{\det\_inc}^2 - V_{\det\_refl}^2 \right),$$

   where $V_{\det\_inc}$ is a detected voltage of an incident component of the power output signal, $V_{det\_refl}$ is a detected voltage of a reflected component of the power output signal, and n is a coefficient having a dimension of 1/volt; and
   determining the detected output power level $P_{out}$ based on

$$P_{out} = \frac{V_{det}}{n \times Z_1 \times k},$$

where $Z_1$ is a termination impedance of the coupler (130), and k is a coupling factor of the coupler (130).

$$P_{out} = \frac{V_{det}}{n \times Z_1 \times k},$$

FIGURE 1

FIGURE 2

302 → Generate output signal from power amplifier

304 → Detect power level of output signal

306 → Generate power detection output signal

308 → Control power amplifier to adjust power level of output signal

FIGURE 3